# EUROPÄISCHE PATENTSCHRIFT

(11) **EP 2 107 974 B1**
(45) Veröffentlichungstag und Bekanntmachung des Hinweises auf die Patenterteilung: **19.05.2010**
(21) Anmeldenummer: 07822434.2
(22) Anmeldetag: 09.11.2007
(51) Int. Cl.: B60C 23/04

(54) **ENERGIEERZEUGENDE EINRICHTUNG FÜR EIN REIFENSENSORMODUL**
ENERGY-GENERATING DEVICE FOR A TYRE SENSOR MODULE
DISPOSITIF DE PRODUCTION D'ÉNERGIE POUR MODULE DE DÉTECTION DE BANDAGE DE VÉHICULE

(30) Priorität: 09.01.2007 DE 102007001361
(43) Veröffentlichungstag der Anmeldung: 14.10.2009
(73) Patentinhaber: Robert Bosch GmbH, 70442 Stuttgart (DE)
(72) Erfinder: PANNEK, Thorsten, 70176 Stuttgart (DE)
(86) Internationale Anmeldenummer: PCT/EP2007/062145
(87) Internationale Veröffentlichungsnummer: WO 2008/083872

(56) Entgegenhaltungen:
- DE-A1- 19 522 269
- DE-A1-102004 031 810
- GB-A- 2 064 883
- US-A1- 2006 175 937

## Beschreibung

Die Erfindung betrifft eine energieerzeugende Einrichtung für ein Reifensensormodul, ein Reifensensormodul mit einer derartigen energieerzeugenden Einrichtung sowie einen Fahrzeugreifen mit einem derartigen Reifensensormodul.

### Stand der Technik

In Fahrzeugreifen werden Sensormodule zur Messung von Zustandsgrößen, z.B. des Reifendrucks, der Reifentemperatur, der auftretenden Kräfte sowie des Reibwertes eingesetzt. Die Sensormodule müssen unter anderem zum Betrieb ihrer Sensorelemente und zur Übertragung von Signalen an eine fahrzeugseitigen Sende- und Empfangseinrichtung mit elektrischer Leistung versorgt werden.

Hierzu sind zum einen Sensormodule mit galvanischen Elementen, d.h. Batterien bekannt. Ihre Lebensdauer ist jedoch begrenzt, weiterhin treten bei der Entsorgung des Fahrzeugreifens Umweltbelastungen auf:

Aus der DE 10 2004 031810 A1 ist ein Sensormodul mit autonomer Energieversorgung bekannt. Hierbei wird im Allgemeinen der im Reifen auftretende Stress bzw. die Deformation in Energie umgewandelt. Weiterhin ist die Verwendung von piezoelektrischen Folien aus organischem Material wie PVDF (Polyvinylidenfluorid) bekannt. Die Folien liefern zwar genug Energie, sie unterliegen jedoch einer geringen Temperaturstabilität und degenerieren daher relativ schnell. Weiterhin ist die Verbindung der Folien mit dem Sensor schwierig. Eine Verkabelung ist bereits aus Zuverlässigkeitsgründen problematisch.

### Offenbarung der Erfindung

Der Erfindung liegt der Gedanke zugrunde, ein Piezoelement derartig aufzunehmen, dass es in zwei unterschiedlichen Biegezuständen stabile Stellungen annimmt. Diese Biegezustände können insbesondere Wölbungen sein, indem das Piezoelement an seinen gegenüberliegenden Enden eingespannt wird und zwischen den Einspannbereichen eine Wölbung nach oben oder nach unten ausbilden kann. Somit werden zwei stabile Biegestellungen mit instabilen Zwischenbereichen gebildet. Das Piezoelement ist hierzu vorteilhafterweise mechanisch vorgespannt, um stabile Biegestellungen auszubilden.

Die Verstellung zwischen den beiden Biegestellungen erfolgt in eine erste Richtung über eine mechanische Rückstelleinrichtung, die bei einer hinreichenden mechanischen Verformung gegen das Piezoelement gelangt und dieses in die andere stabile Biegestellung zurück verstellt. Als Verformung wird vorteilhafterweise der Übergang in den Bereich der Reifenaufstandsfläche genutzt.

Als Verstellung in die entgegen gesetzte zweite Richtung wird vorteilhafterweise die auf das Piezoelement und vorzugsweise ergänzende Masseelemente wirkende Trägheitskraft, d.h. insbesondere die Fliehkraft genutzt. Dem liegt die erfindungsgemäße Erkenntnis zu Grunde, dass in der Reifenaufstandsfläche nur Tangential- aber keine Radialkräfte und somit auch keine Zentrifugalkräfte auf das Piezoelement und dessen zusätzlichen Masseelemente einwirken, so dass die von der mechanischen Rückstelleinrichtung aufzubringende Verstellkraft in die erste Richtung begrenzt ist.

Somit sind bei einer Reifenumdrehung zwei Verstellungen zwischen den beiden stabilen Endstellungen möglich, nämlich beim Übergang des Sensormoduls in den Bereich der Reifenaufstandsfläche und beim Verlassen dieses Bereiches, wobei jeweils Energie gewonnen wird.

Durch die hohen mechanische Biegeverformungen zwischen den stabilen Biegestellungen, insbesondere bei zwei unterschiedlichen Wölbungen, können jeweils ein hoher mechanischer Stress und hierdurch eine hohe elektrische Spannung und hohe elektrische Leistung erreicht werden.

Erfindungsgemäß kann insbesondere ein Piezokomposit aus mindestens zwei Lagen, z.B. einer Substratlage und einer piezoelektrischen Lage aus einem keramischen Material, z.B. PZT gebildet werden, das eine hohe mechanische Zuverlässigkeit, eine hohe elektrische Ausgangsspannung bzw. hohe Leistungsabgabe und insbesondere gegenüber organischen Materialien eine höhere Temperaturstabilität ermöglicht. Indem die beiden Lagen unterschiedliche thermische Ausdehnungskoeffizienten aufweisen, wird eine mechanische Vorspannung gebildet, wodurch die ausgebbare elektrische Spannung weiter erhöht ist.

Durch die erfindungsgemäß hohe Leistungsabgabe kann ein Sensormodul mit ein oder mehreren Sensorelementen, Sende- und Empfangseinrichtung und weiteren elektronischen Komponenten autark betrieben werden.

Das Piezoelement ist vorzugsweise in einem Gehäuseteil oder einer gehäusefesten Aufnahme eingespannt. Hierdurch wird eine sichere Befestigung und vorteilhafterweise auch direkt eine elektrische Kontaktierung ermöglicht, ohne hierfür zusätzliche empfindliche Kabel oder weitere Befestigungen vorzusehen. Die Rückstelleinrichtung kann direkt mit einem radial im Reifen weiter außen gelegenen anderen Gehäuseteil verbunden sein, das den Verformungen stärker ausgesetzt ist, so dass die Relativbewegung der Rückstelleinrichtung gegenüber dem Piezoelement erreicht wird.

Durch die Anbringung des Piezoelementes direkt im Gehäuse kann erfindungsgemäß eine hohe Integration und somit geringe Baugröße sowie eine sichere Aufnahme der empfindlichen Teile erreicht werden. Es ist insbesondere auch die Anbringung des Sensormoduls direkt in der Lauffläche des Reifens und somit eine direkte Messung der relevanten Zustandsgrößen, z. B. auch der Vibrationen möglich, wobei die dort auftretenden hohen mechanischen Verformungen zu einer hohen Energieausbeute führen.

### Kurze Beschreibung der Zeichnungen

- Fig. 1: ein Fahrzeugrad mit einem erfindungsgemäßen Sensormodul bei seiner Abrollbewegung in Seitenansicht;
- Fig. 2: eine energieerzeugende Einrichtung gemäß einer Ausführungsform in einer ersten Biegestellung außerhalb der Reifenaufstandsfläche;
- Fig. 3: die energieerzeugende Einrichtung in einer zweiten Biegestellung in der Reifenaufstandsfläche;
- Fig. 4: eine Darstellung des Piezoelementes in den Biegestellungen.

### Ausführungsformen der Erfindung

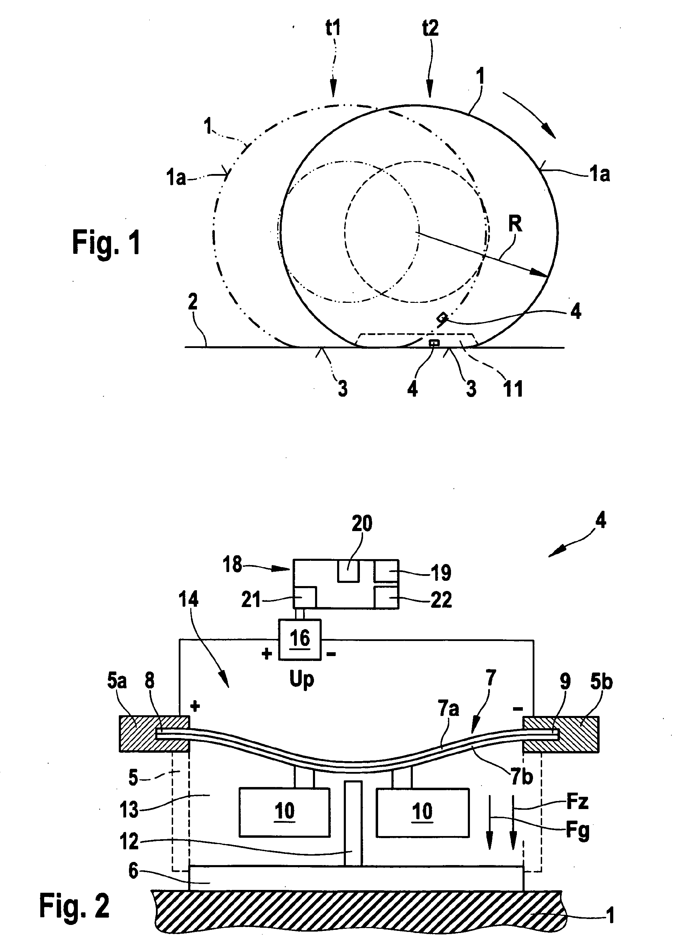

Ein Reifen 1 eines der Räder eines Fahrzeuges rollt während der Fahrt auf einer Fahrbahn 2 ab. In Fig. 1 sind hierbei die Positionen in zwei aufeinander folgenden Zeitpunkten t1, t2 gezeigt. Der Reifen 1 weist in seiner Außenfläche 1 a außerhalb seiner Reifenaufstandsfläche 3 eine im Wesentlichen gleichmäßig gekrümmte Form auf und liegt mit seiner Reifenaufstandsfläche 3 (Latsch, contact patch) auf der Fahrbahn 2 plan bzw. eben auf, so dass sich ein deformierter Reifenbereich 11 oberhalb der Reifenaufstandsfläche 3 ausbildet.

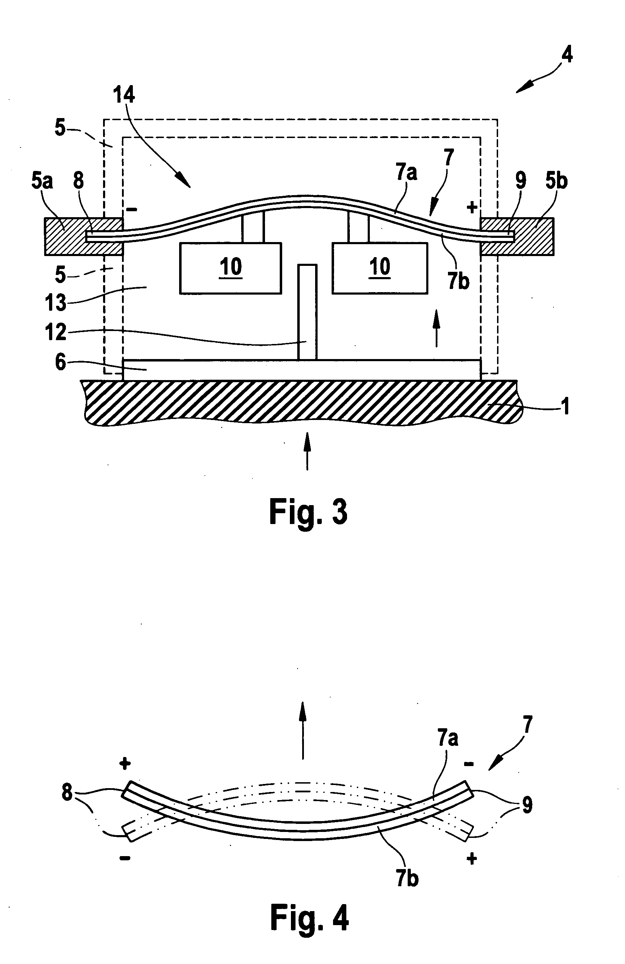

In dem Reifen 1 ist ein erfindungsgemäßes Sensormodul 4 aufgenommen. Das Sensormodul 4 weist ein in Fig. 2, 3 zum Teil gestrichelt schematisch eingezeichnetes Gehäuse 5, 6 auf, das erfindungsgemäß unter Druckbeanspruchung verformbar oder verstellbar ist. Hierzu kann das Gehäuse z. B. ein Gehäuseoberteil 5 und ein Gehäuseunterteil 6 aufweisen. Hierbei ist das Gehäuseunterteil 6 gegenüber dem Gehäuseoberteil 5 in vertikaler bzw. - bezüglich des Reifens 1 - radialer Richtung R verstellbar. Hierzu kann das Gehäuseunterteil 6 mit dem Gehäuseoberteil 5 einteilig und z.B. elastisch verstellbar ausgebildet sein. Weiterhin ist auch eine zweiteilige Ausbildung mit separatem Gehäuseoberteil 5 und Gehäuseunterteil 6 möglich, bei der das Gehäuseunterteil 6 z.B. in dem Gehäuseoberteil 5 verschiebbar geführt ist. Erfindungsgemäß relevant ist, dass eine Relativverschiebung zwischen dem Gehäuseoberteil 5 und dem Gehäuseunterteil 6 in der radialen Richtung R möglich ist und trotzdem eine hinreichende Abdichtung des Gehäuseinnenraums 13 gegenüber den Belastungen beim Einvulkanisieren in das Gummimaterial des Reifens erreicht wird. In Fig. 2 ist der Übersichtlichkeit halber nur der untere Bereich des Gehäuseoberteils 5 dargestellt.

In dem Gehäuseinnenraum 13 ist ein Piezoelement 7 als piezoelektrischer Kompositwerkstoff mit mehreren, vorzugsweise zwei miteinander verbundene, z. B. gebondeten Lagen 7a, b ausgebildet, wobei zumindest eine Lage 7a aus einem piezoelektrischen Keramikmaterial, vorzugsweise PZT (Bleizirkonat-Titanat) hergestellt ist. Die zweite Lage 7b ist aus einem anderen Material mit gegenüber der piezoelektrischen Lage 7a unterschiedlichem thermischen Aufdehnungskoeffizienten hergestellt, so dass das gesamte Piezoelement 7 eine mechanische Vorspannung erhält, wie in Fig. 4 dargestellt. Entsprechend seiner mechanischen Deformation bzw. seiner mechanischen Durchbiegung bildet das Piezoelement 7 an seinen zum Spannungsabgriff dienenden Enden 8, 9, d.h. den Enden seiner piezoelektrischen Lage 7a, eine Piezospannung Up aus, deren Polarität von der Richtung der Wölbung abhängt.

Das Piezoelement 7 kann sich von seiner instabilen, horizontalen, stark gespannten Zwischenstellung somit durch Wölbung nach oben oder unten in eine der beiden stabilen Biegestellungen entspannen. In der unteren Biegestellung der Fig. 2 ist die obere piezoelektrische Lage 7a auf Druck gestaucht und gibt eine Piezospannung Up einer ersten Polarität aus, wobei die als Substrat dienende untere zweite Lage 7b unter Zugspannung steht. Entsprechend steht in der oberen Biegestellung der Fig. 3 die obere piezoelektrische Lage 7a unter Zugspannung und gibt eine Piezospannung Up einer zweiten, entgegen gesetzten Polarität aus, wobei die als Substrat dienende untere zweite Lage 7b auf Druck gestaucht ist. Bei einer wechselnden Biegebelastung alterniert entsprechend die Piezospannung Up im Vorzeichen.

Die Form des Piezoelementes 7 kann entsprechend dem gewünschten Elastizitätsmodul und der erforderlichen elektrischen Spannung gewählt werden. Hierbei kann auch eine kreissymmetrische Form, d.h. eine im Grundzustand gewölbte, z.B. kugelschalenförmige bzw. schalottenförmige Ausbildung des Piezoelementes 7 wie ein "Knackfrosch" gewählt werden.

Das als Piezokomposit aus den zwei Lagen 7a, 7b gebildete Piezoelement 7 schnappt als bistabiles System zwischen den beiden Wölbungszuständen vollständig durch, wodurch eine hohe Auslenkung und somit eine hohe elektrische Ausgangsleistung erreicht wird.

Das mehrlagige Piezoelement 7 ist an seinen Enden 8 und 9 fest in Gehäuseaufnahmen 5a, b des Gehäuseoberteils 5 aufgenommen. Die Gehäuseaufnahmen 5a, b dienen neben der mechanischen Einspannung des Piezoelementes 7 auch der elektrischen Kontaktierung der Enden 8,9 des Piezoelementes 7. In einem mittleren Bereich zwischen seinen Enden 8, 9 ist an den Piezoelement 7 eine Masseeinrichtung, z.B. gemäß Fig. 2, 3 zwei Masseelemente 10 oder auch z.B. ein ringförmiges, durchgängiges Masseelement 10 angebunden. Die Masseelemente 10 können grundsätzlich auf der Ober- oder Unterseite des Piezoelementes 7 befestigt sein.

Am Gehäuseunterteil 6 ist ein nach oben ragender Dorn 12 befestigt, der in der mit Fig. 2 gezeigten oberen Biegestellung bis etwas unterhalb der Mitte des Piezoelementes 7 ragt, dieses jedoch nicht deformiert. Das Sensormodul 4 ist derartig in der Lauffläche des Reifens 1 aufgenommen, dass das Gehäuseunterteil 6 mit dem Dorn 12 radial weiter außen und das Gehäuseoberteil 5 mit dem Piezoelement 7 radial weiter innen angeordnet ist, so dass das Gehäuseunterteil 6 bei der Deformation des Reifens 1 bei dessen Abrollbewegung zu dem Gehäuseoberteil 5 hin verstellt wird, so dass der Dorn 12 nach oben gedrückt wird und gegen die mechanische Vorspannung des nach unten gewölbten Piezoelementes 7 sowie gegen die von dem Piezoelement 7 und dem mindestens einem Masseelement 10 ausgeübte Trägheitskraft wirkt. Die auf das Piezoelement 7 und das Masselement 10 wirkende Trägheitskraft Fg setzt sich aus der Gravitationskraft Fg= m x g mit g ≈ 10m/s² sowie der Zentrifugalkraft Fz = v² / r zusammen, mit r= Krümmungsradius der Bahn des Piezoelementes 7. Der Krümmungsradius entspricht außerhalb der Reifenaufstandsfläche 3 bzw. des deformierten Reifenbereichs 11 im wesentlichen dem Reifenradius R, in der planen Reifenaufstandsfläche 3 ist r = unendlich, d.h. es wird eine Tangentialbewegung beschrieben, bei der die Zentrifugalkraft bzw. Fliehkraft Null wird; auch in dem an die Reifenaufstandsfläche 3 angrenzenden deformierten Reifenbereich 11 verschwindet die Zentrifugalkraft bzw. nimmt nach oben hin zunächst einen sehr geringen Wert an.

Außerhalb des deformierten Reifenbereichs 11, d.h. über einen Großteil der Rotationsbewegung, befindet sich die energieerzeugende Einrichtung 14 in der in Fig. 2 gezeigten unteren Biegestellung. Das mindestens eine Masseelement 10 wird durch die Zentrifugalkraft Fz des sich drehenden Fahrzeugreifens 1 radial nach außen beschleunigt; die Radialkomponente der auf das Masseelement 10 wirkenden Gravitationskraft Fg hängt von der Orientierung bzw. Drehposition der energieerzeugenden Einrichtung 14 im Reifen 1 ab, ist jedoch gegenüber der Zentrifugalkraft Fz und auch der Vorspannung F des Piezoelementes 7 sehr gering.

Sobald das Sensormodul 4 mit seiner energieerzeugenden Einrichtung 14 nach unten in den deformierten Reifenbereich 11 oberhalb der Reifenaufstandsfläche 3 gelangt, wird das Gehäuseunterteil 6 relativ zum Gehäuseoberteil 5 nach oben verstellt und drückt mit dem Dorn 12 das Piezoelement 7 nach oben gegen dessen Vorspannung sowie gegen die auf das Masseelement 10 wirkende Zentrifugalkraft Fz, bis dieses nach Erreichen einer mittleren Lage nach oben durchschnappt und somit die in Fig. 3 gezeigte obere Biegestellung einnimmt

Hierbei ist im deformierten Reifenbereich 11 oberhalb der flachen Reifenaufstandsfläche 3 das Sensormodul 4 und somit die energieerzeugende Einrichtung 14 wie oben beschrieben lediglich der Tangentialbewegung ausgesetzt, d.h. auf die energieerzeugende Einrichtung 14 wirkt lediglich eine zu vernachlässigende tangentiale Komponente der Beschleunigung, nämlich die Beschleunigung des Fahrzeuges in Längsrichtung bzw. X-Richtung sowie die Gravitationskraft Fg in radialer Richtung senkrecht zur Reifenoberfläche, d.h. hier in der vertikalen Z-Richtung. Erfindungsgemäß wird somit erkannt, dass in der Reifenaufstandsfläche 3 selbst keine Zentrifugalkräfte auftreten und die auf das Piezoelement 7 nach unten wirkende Kraft somit sehr klein ist und nur von der Masse des Masseelementes 10 sowie der Eigenmasse des Piezoelementes 7 abhängt.

Verlässt das Sensormodul 4 mit der energieerzeugenden Einrichtung 14 den deformierten Bereich 11 oberhalb der flachen Reifenaufstandsfläche 3, so tritt es wieder in eine Kreisbahn mit im wesentlichen dem Radius R des Reifens 1 und ist somit einer von der Drehzahl des Reifens 1 abhängigen Radialbeschleunigung ausgesetzt, die je nach Geschwindigkeit zwischen einigen 100 und 10.000 m/s² liegen kann.

Damit wirken außerhalb der Reifenaufstandsfläche 3 somit deutlich höhere Zentrifugalkräfte Fz in radialer Richtung zu der Reifenoberfläche 1 a hin und ziehen das Piezoelement 7 wieder in die nach unten gewölbte Biegestellung der Fig. 2 zurück. Hierbei ist die Gesamtmasse aus dem Piezoelement 7 und dem Masseelement 10 derartig angepasst, dass die Zentrifugalkraft Fz ausreichend ist, um das Piezoelement 7 wieder zurückschnappen zu lassen.

Grundsätzlich ist es erfindungsgemäß möglich, dass zwischen dem Gehäuseoberteil 5 und dem Gehäuseunterteil 6 ergänzend eine relativ kleine elastische Federwirkung ausgebildet ist, die das Gehäuseunterteil 6 außerhalb der Reifenaufstandsfläche 3 wieder nach außen drückt.

Bei den Verstellungen von der Biegestellung der Fig. 2 in die Biegestellung der Fig. 3 sowie auch dem Rückstellvorgang werden Piezospannungen Up mit unterschiedlicher Polarität bzw. unterschiedlichem Vorzeichen erzeugt. Gemäß der schematischen Darstellung der Fig. 2 sind die der Kontaktierung dienenden Gehäuseaufnahmen 5a, 5b mit einer Gleichrichterschaltung 16 verbunden, die die gleichgerichtete Spannung an eine weitere elektrische Schaltung 18 des Sensormoduls 4 abgibt. Die elektrische Schaltung 18 weist hierbei unter anderem den elektrisch ausgelesenen Sensor 19 des Sensormoduls 4, weiterhin eine Steuereinrichtung 22, eine Sende- und Empfangseinrichtung 20 zur Signalübertragung an eine entsprechende Sende- und Empfangseinrichtung am Fahrzeug und von dieser und vorteilhafterweise einen Energiespeicher 21, z.B. einen Kondensator auf, der auch in den Zeiträumen zwischen der Deformation, d.h. während der restlichen Reifenumdrehung außerhalb der Reifenaufstandsfläche 3, eine Energieversorgung gewährleistet.

Der Sensor 19 kann z.B. der Messung des Reifendrucks, der Beschleunigung, der Temperatur und/oder des Reibwertes dienen. Weiterhin sind noch zusätzliche elektrische Funktionen der elektrischen Schaltung 18 möglich.

## Patentansprüche

1. Energieerzeugende Einrichtung (14) für ein Reifensensormodul (4) eines Fahrzugreifens (1), die aufweist:
ein Piezoelement (7), das zwischen einer ersten stabilen Biegestellung und einer zweiten stabilen Biegestellung verstellbar ist und bei der Verstellung zwischen den stabilen Biegestellungen eine elektrische Piezospannung (Up) ausgibt, und
eine Rückstelleinrichtung (12) zur mechanischen Verstellung des Piezoelementes (7) von der ersten stabilen Biegestellung in die zweite stabile Biegestellung,
wobei die Rückstelleinrichtung (12) durch eine auf die energieerzeugende Einrichtung (14) einwirkende Deformation aktivierbar ist

2. Energieerzeugende Einrichtung nach Anspruch 1, **dadurch gekennzeichnet, dass** die Rückstelleinrichtung (12) aktivierbar ist, wenn die energieerzeugende Einrichtung (14) in einem deformierten Reifenbereich (11) des Fahrzeugreifens (1) oberhalb seiner Reifenaufstandsfläche (3) angeordnet ist.

3. Energieerzeugende Einrichtung nach Anspruch 2, **dadurch gekennzeichnet, dass** bei einer Position außerhalb des deformierten Reifenbereichs (11) eine bei Drehung des Fahrzugreifens (1) auf das Piezoelement (7) ausgeübte Zentrifugalkraft (Fz) das Piezoelement (7) in die erste stabile Lage drückt.

4. Energieerzeugende Einrichtung nach einem der vorherigen Ansprüche, **dadurch gekennzeichnet, dass** an dem Piezoelement (7) mindestens ein Masseelement (10) zur Vergrößerung einer einwirkenden Trägheitskraft, insbesondere einer bei Raddrehung einwirkenden Zentrifugalkraft (Fz) vorgesehen ist.

5. Energieerzeugende Einrichtung nach einem der vorherigen Ansprüche, **dadurch gekennzeichnet, dass** das Piezoelement (7) mit seinen Endbereichen (8, 9) in Aufnahmen (5a, b) eingespannt ist und zwei entgegengesetzt gewölbte stabile Biegestellungen mit instabilen Zwischenzuständen aufweist.

6. Energieerzeugende Einrichtung nach Anspruch 5, **dadurch gekennzeichnet, dass** die Aufnahmen (5a, b) mit einem ersten Gehäusebereich (5) verbunden sind, und die Rückstelleinrichtung (12) mit einem zweiten Gehäusebereich (6) verbunden ist, der bei Einwirkung der Deformation auf die energieerzeugende Einrichtung (14) gegenüber dem ersten Gehäusebereich (5) verstellt ist.

7. Energieerzeugende Einrichtung nach Anspruch 6, **dadurch gekennzeichnet, dass** der zweiten Gehäusebereich (6) ein Gehäuseunterteil (6) ist, das bei einer Krafteinwirkung von unten die Rückstelleinrichtung (12) gegen das Piezoelement (7) drückt, wobei durch eine elastische Rückstellkraft des Piezoelementes (7) und durch Trägheitskräfte (Fg, Fz) des Piezoelementes (7) eine Gegenkraft ausgeübt wird.

8. Energieerzeugende Einrichtung nach einem der Ansprüche 5 bis 7, **dadurch gekennzeichnet, dass** die Aufnahmen (5a, b) für die Enden (8, 9) des Piezoelementes (7) auch der elektrischen Kontaktierung und dem Abgriff der Piezospannung (Up) dienen.

9. Energieerzeugende Einrichtung nach einem der vorherigen Ansprüche, **dadurch gekennzeichnet, dass** das Piezoelement (7) mindestens zwei miteinander verbundene, z. B. gebondete Lagen (7a, ) mit unterschiedlichen thermischen Ausdehnungskoeffizienten und einer mechanische Vorspannung gegeneinander aufweist, von denen mindestens eine Lage eine piezoelektrische Lage (7a) zur Ausgabe der Piezospannung (Up) bei Verstellung zwischen den beiden stabilen Biegestellungen ist.

10. Energieerzeugende Einrichtung nach Anspruch 9, **dadurch gekennzeichnet, dass** die piezoelektrische Lage (7a) aus einem keramischen piezoelektrischen Material, z.B. einem Bleizirkonat-Titanat, gefertigt ist.

11. Energieerzeugende Einrichtung nach einem der vorherigen Ansprüche, **dadurch gekennzeichnet, dass** sie eine Gleichrichterschaltung (16) zur Gleichrichtung der Piezospannung (Up) unterschiedlicher Polarität aufweist.

12. Energieerzeugende Einrichtung nach einem der vorherigen Ansprüche, **dadurch gekennzeichnet, dass** die Rückstelleinrichtung (12) ein nach oben und im Wesentlichen mittig gegen das Piezoelement (7) ragender Dorn (12) ist.

13. Reifensensormodul (4) zur Anbringung in einem Fahrzeugreifen (1), das eine energieerzeugende Einrichtung (14) nach einem der vorherigen Ansprüche, einen Sensor (19) zur Messung einer Zustandsgröße eines Fahrzeugreifens (1) und eine Sende- und Empfangseinrichtung (20) zur Signalaustausch mit einer am Fahrzeug vorgesehene Sende- und Empfangseinrichtung aufweist,
wobei das Reifensensormodul energetisch autark ist und die energieerzeugende Einrichtung (14) den Sensor (19) und die Sende- und Empfangseinrichtung (20) mit elektrischer Leistung versorgt.

14. Reifensensormodul nach Anspruch 13, **dadurch gekennzeichnet, dass** es weiterhin einen Energiespeicher (21) zur Zwischenspeicherung der von der energieerzeugenden Einrichtung (14) erzeugten Energie aufweist.

15. Fahrzeugreifen (1), in dessen Gummimaterial, insbesondere in seiner Lauffläche, ein Reifensensormodul (4) nach Anspruch 13 oder 14 angebracht ist.

## Claims

1. Energy-generating device (14) for a tyre sensor module (4) of a vehicle tyre (1), which energy-generating device has:
a piezo element (7) which can be adjusted between a first stable bending position and a second stable bending position and outputs an electric piezo voltage (Up) in the event of adjustment between the stable bending positions, and
a restoring device (12) for mechanically adjusting the piezo element (7) from the first stable bending position to the second stable bending position,
wherein the restoring device (12) can be activated by a deformation which acts on the energy-generating device (14).

2. Energy-generating device according to Claim 1, **characterized in that** the restoring device (12) can be activated when the energy-generating device (14) is arranged in a deformed tyre region (11) of the vehicle tyre (1) above the ground contact area (3) of the said vehicle tyre.

3. Energy-generating device according to Claim 2, **characterized in that,** in a position outside the deformed tyre region (11), a centrifugal force (Fz), which is exerted on the piezo element (7) when the vehicle tyre (1) turns, pushes the piezo element (7) into the first stable position.

4. Energy-generating device according to one of the preceding claims, **characterized in that** at least one mass element (10) for increasing an active inertial force, in particular a centrifugal force (Fz) which acts when the wheel turns, is provided on the piezo element (7).

5. Energy-generating device according to one of the preceding claims, **characterized in that** the piezo element (7) is clamped into receptacles (5a, b) by way of its end regions (8, 9) and has two stable bending positions which are curved in opposite directions and have unstable intermediate states.

6. Energy-generating device according to Claim 5, **characterized in that** the receptacles (5a, b) are connected to a first housing region (5), and the restoring device (12) is connected to a second housing region (6) which is adjusted in relation to the first housing region (5) when the deformation acts on the energy-generating device (14).

7. Energy-generating device according to Claim 6, **characterized in that** the second housing region (6) is a housing lower part (6) which pushes the restoring device (12) against the piezo element (7) when a force acts from below, with a counter-force being exerted by an elastic restoring force of the piezo element (7) and by inertial forces (Fg, Fz) of the piezo element (7).

8. Energy-generating device according to one of Claims 5 to 7, **characterized in that** the receptacles (5a, b) for the ends (8, 9) of the piezo element (7) also serve to make electrical contact and to tap off the piezo voltage (Up).

9. Energy-generating device according to one of the preceding claims, **characterized in that** the piezo element (7) has at least two layers (7a, 7b) which are connected, for example bonded, to one another and have different coefficients of thermal expansion and are mechanically prestressed relative to one another, at least one layer of said at least two layers being a piezoelectric layer (7a) for outputting the piezo voltage (Up) in the event of adjustment between the two stable bending positions.

10. Energy-generating device according to Claim 9, **characterized in that** the piezoelectric layer (7a) is produced from a ceramic piezoelectric material, for example a lead zirconate titanate.

11. Energy-generating device according to one of the preceding claims, **characterized in that** it has a rectifier circuit (16) for rectifying the piezo voltage (Up) of different polarity.

12. Energy-generating device according to one of the preceding claims, **characterized in that** the restoring device (12) is a pin (12) which projects upward and substantially centrally relative to the piezo element (7).

13. Tyre sensor module (4) to be fitted in a vehicle tyre (1), which tyre sensor module has an energy-generating device (14) according to one of the preceding claims, a sensor (19) for measuring a state variable of a vehicle tyre (1) and a transceiver device (20) for exchanging signals with a transceiver device which is provided on the vehicle,
with the tyre sensor module having an autonomous power supply and the energy-generating device (14) supplying electrical power to the sensor (19) and the transceiver device (20).

14. Tyre sensor module according to Claim 13, **characterized in that** it also has an energy storage means (21) for buffer-storing the energy generated by the energy-generating device (14).

15. Vehicle tyre (1), the rubber material, in particular the running area, of which is fitted with a tyre sensor module (4) according to Claim 13 or 14.

## Revendications

1. Dispositif (14) de production d'énergie pour module (4) de détecteur de bandage (1) de roue de véhicule, qui présente :
un piézoélément (7) qui peut être déplacé entre une première position fléchie stable et une deuxième position fléchie stable et qui délivre une tension piézoélectrique (Up) lors du basculement entre les positions fléchies stables,
un dispositif de rappel (12) qui rappelle mécaniquement le piézoélément (7) depuis la première position fléchie stable jusque dans la deuxième position fléchie stable,
le dispositif de rappel (12) pouvant être une déformation qui agit sur le dispositif (14) de production d'énergie.

2. Dispositif de production d'énergie selon la revendication 1, **caractérisé en ce que** le dispositif de rappel (12) peut être activé si le dispositif (14) de production d'énergie est disposé dans une partie déformée (11) du bandage (1) de roue de véhicule au-dessus de sa surface (3) de pose sur le bandage.

3. Dispositif de production d'énergie selon la revendication 2, **caractérisé en ce que** si sa position est située à l'extérieur de la partie déformée (11) du bandage, une force centrifuge (Fz) exercée sur le piézoélément (7) lorsque le bandage (1) de roue de véhicule est en rotation repousse le piézoélément (7) dans la première position stable.

4. Dispositif de production d'énergie selon l'une des revendications précédentes, **caractérisé en ce que** le piézoélément (7) présente au moins un élément de masse (10) qui augmente la force d'inertie active, en particulier la force centrifuge (Fz) qui agit lorsque la roue tourne.

5. Dispositif de production d'énergie selon l'une des revendications précédentes, **caractérisé en ce que** le piézoélément (7) est serré par ses parties d'extrémité (8, 9) dans des logements (5a, b) et **en ce qu'**il présente deux positions fléchies stables cintrées dans des sens opposés et des positions intermédiaires instables.

6. Dispositif de production d'énergie selon la revendication 5, **caractérisé en ce que** les logements (5a, b) sont reliés à une première partie de boîtier (5), le dispositif de rappel (12) étant relié à une deuxième partie de boîtier (6) qui est déplacée par rapport à la première partie de boîtier (5) lorsqu'une déformation agit sur le dispositif (14) de production d'énergie.

7. Dispositif de production d'énergie selon la revendication 6, **caractérisé en ce que** la deuxième partie de boîtier (6) est une partie inférieure de boîtier (6) qui repousse le dispositif de rappel (12) contre le piézoélément (7) lorsqu'une force agit depuis le bas et **en ce qu'**une force de réaction est exercée par la force élastique de rappel du piézoélément (7) et les forces d'inertie (Fg, Fz) du piézoélément (7) exercent.

8. Dispositif de production d'énergie selon l'une des revendications 5 à 7, **caractérisé en ce que** les logements (5a, b) prévus pour les extrémités (8, 9) du piézoélément (7) servent également à assurer le contact électrique et le prélèvement de la tension piézoélectrique (Up).

9. Dispositif de production d'énergie selon l'une des revendications précédentes, **caractérisé en ce que** le piézoélément (7) présente au moins deux couches (7a, 7b) reliées l'une à l'autre, par exemple par métallisation, dont les coefficients de dilatation thermique sont différents, qui exercent l'une sur l'autre une précontrainte mécanique et dont au moins l'une est une couche piézoélectrique (7a) qui délivre la tension piézoélectrique (Up) lors du basculement entre les deux positions fléchies stables.

10. Dispositif de production d'énergie selon la revendication 9, **caractérisé en ce que** la couche piézoélectrique (7a) est constituée d'un matériau piézoélectrique céramique, par exemple du zirconate-titanate de plomb.

11. Dispositif de production d'énergie selon l'une des revendications précédentes, **caractérisé en ce qu'**il présente un circuit redresseur (16) qui redresse les tensions piézoélectriques (Up) de polarités différentes.

12. Dispositif de production d'énergie selon l'une des revendications précédentes, **caractérisé en ce que** le dispositif de rappel (12) est un pointeau (12) qui déborde vers le haut et essentiellement centralement contre le piézoélément (7).

13. Module (4) de détecteur de bandage de roue destiné à être placé sur un bandage (1) de roue de véhicule et qui présente
un dispositif (14) de production d'énergie selon l'une des revendications précédentes,
un détecteur (19) qui mesure une grandeur d'état du bandage (1) de roue de véhicule et
un dispositif d'émission et de réception (20) qui assure l'échange des signaux avec un dispositif d'émission et de réception prévu sur le véhicule,
le module de détecteur de bandage de roue étant énergétiquement autonome et
le dispositif (14) de production d'énergie alimentant le détecteur (19) et le dispositif d'émission et de réception (20) en énergie électrique.

14. Module de détecteur de bandage de roue selon la revendication 13, **caractérisé en ce qu'**il présente en outre un accumulateur d'énergie (21) qui accumule temporairement l'énergie délivrée par le dispositif (14) de production d'énergie.

15. Bandage (1) de roue de véhicule qui présente dans son matériau de caoutchouc et en particulier dans sa surface de roulement un module (4) de détecteur de bandage de roue selon les revendications 13 ou 14.
